# EUROPÄISCHE PATENTANMELDUNG

(11) **EP 2 568 061 A2**
(43) Veröffentlichungstag der Anmeldung: **13.03.2013**
(21) Anmeldenummer: 12183118.4
(22) Anmeldetag: 05.09.2012
(51) Int. Cl.: C23C 16/455, C23C 16/452, C23C 16/507

(54) **Vorrichtung und Verfahren zur Beschichtung eines Substrates**

(30) Priorität: 06.09.2011 DE 102011112897
(71) Anmelder: SENTECH Instruments GmbH, 12489 Berlin (DE)
(72) Erfinder: Rudolph, Rolf, 13187 Berlin (DE); Gargouri, Hassan, 12524 Berlin (DE); Arens, Michael, 12099 Berlin (DE); Wiek, Helmut, 82152 Krailling (DE); Krüger, Albrecht, 12623 Berlin (DE)
(74) Vertreter: Morawski, Birgit

(57) **Zusammenfassung**

Beschichtungsvorrichtung für Substrate, gekennzeichnet durch eine Prozesskammer (10), die mit mindestens einem ersten Quellensystem (30) für Reaktanden und gegebenenfalls Trägergase und mindestens einem gepulst betreibbaren zweiten Quellensystem (70) für Reaktanden und gegebenenfalls Trägergase gekoppelt ist, so dass mindestens zwei Plasmabeschichtungen in der gemeinsamen Prozesskammer (10) durchführbar sind.

## Beschreibung

Die Erfindung betrifft eine Vorrichtung zur Beschichtung eines Substrates mit den Merkmalen des Anspruch 1 und ein Verfahren zur Beschichtung eines Substrates mit den Merkmalen des Anspruchs 12.

Für das Aufbringen von dünnen Schichten auf Substraten, z.B. Wafern in der Herstellung von Halbleiterbauelementen, sind verschiedene Verfahren bekannt.

So sind Plasmabeschichtungsanlagen zum Aufbringen von Siliziumoxidschichten, Siliziumnitridschichten, Siliziumoxynitridschichten, amorphen Schichten oder mikrokristallinen Siliziumschichten und / oder diamantähnlichen CH-Schichten bekannt. Diese Schichten können z.B. als Funktionsschichten in Bauelementen, als Passivierungsschichten und / oder als Maskenschichten auf dem Substrat verwendet werden. Grundsätzlich können Plasmabeschichtungen (PECVD) kontinuierlich für die Herstellung von funktionellen Schichten in Halbleiterbauelementen oder gepulst für die Herstellung von diamantähnlichen Kohlenstoffschichten (DLC-Schichten: Diamond Like Carbon)vorgenommen werden.

Ein anderes an sich bekanntes Beschichtungsverfahren ist die Atomic Layer Deposition (ALD), entweder ohne Plasmaquelle als thermische ALD (TALD) oder mit Plasmaquelle als Plasma-ALD (PALD). Eine Weiterentwicklung dieses Verfahrens ist die Molecular Layer Deposition (MLD).

Typischerweise werden dabei Schichten aus Metalloxiden, Halbleiteroxiden, Metallnitriden, Halbleiter-Nitriden oder Metallen als Funktionsschichten auf einem Substrat abgeschieden. ALD-Verfahren werden gepulst und zyklisch ausgeführt.

In beiden Verfahren können als Substrate z.B. Halbleiterwafer, Metallsubstrate oder dielektrische Substrate (z.B. aus Glas) verwendet werden.

Dabei ist häufig wünschenswert, beide unterschiedliche Verfahren, z.B. gepulste und nicht-gepulste Verfahren bei der Bearbeitung eines Substrates zu verwenden, da mit den beiden Verfahren sehr unterschiedliche Schichteigenschaften erzielbar sind.

Jedes der beiden Beschichtungsverfahren wird dabei in einer separaten Anlage oder einer separaten Kammer ausgeführt, so dass das jeweilige Substrat von einer Anlage oder Kammer in die nächste transportiert werden muss. Dies ist aufwändig und kostenintensiv und kann dazu führen, dass das Substrat während des Transportes kontaminiert wird.

Es besteht daher die Aufgabe, Vorrichtungen und Verfahren zu entwickeln, mit denen eine effizientere Beschichtung möglich ist.

Dies ist mit einer Prozesskammer möglich, die mit mindestens einem ersten Quellensystem für Reaktanden (und gegebenenfalls Trägergase) und mindestens einem gepulst betreibbaren zweiten Quellensystem für Reaktanden (und gegebenenfalls Trägergase) gekoppelt ist, so dass eine gepulste Beschichtung und eine weitere Beschichtung in der gemeinsamen Prozesskammer durchführbar sind. Durch die Kopplung einer Prozesskammer mit zwei unterschiedlichen Quellensystemen für Reaktanden ist es möglich, zwei unterschiedliche Prozesse in ein und derselben Prozesskammer zu betreiben.

Vorteilhafte Ausführungsformen weisen als zweites Quellensystem ein gepulstes Quellensystem für ein MLD-Verfahren, ein ALD-Verfahren oder ein CVD-Verfahren auf. Diese Verfahren können dann im Zusammenwirken mit einem anderen, z.B. kontinuierlichen Verfahren in der gemeinsamen Prozesskammer durchgeführt werden. Insbesondere sind eine gepulste ALD-Beschichtung und eine kontinuierliche Plasmabeschichtung in der gemeinsamen Prozesskammer durchführbar.

Zur Vermeidung von Ablagerungen ist es vorteilhaft, wenn Ausführungsformen ein Mittel, insbesondere einen Sperrschieber, zur zeitweisen Abkopplung einer Prozesspumpe von der Prozesskammer aufweisen. Auf diese Weise kann u.U. die Verweilzeit der Gase und der Reaktanden in der Prozesskammer verlängert werden.

Ferner weisen vorteilhafte Ausführungsformen eine Filtervorrichtung und / oder Abscheidevorrichtung in der Saugleitung einer Prozesspumpe auf, insbesondere für eine Prozesspumpe, die als Turbomolekularpumpe ausgebildet ist.

Da unterschiedliche Beschichtungsprozesse unterschiedliche Prozessvolumina benötigen können, ist es vorteilhaft, wenn ein Mittel zur Anpassung des Prozessvolumens in der Prozesskammer in Abhängigkeit vom Beschichtungsverfahren vorgesehen ist. Vorteilhafterweise weist das Mittel zur Anpassung des Prozessvolumens in der Prozesskammer eine Blendenvorrichtung und / oder ein Mittel zur Bewegung der Substratauflage relativ zur Plasmaquelle auf.

Eine weitere vorteilhafte Ausführungsform weist ein Zusatzplasmaquellensystem für ein Remote-Plasma auf, um aktive chemische Molekülen zu generieren. Damit wird die Effizienz der Prozesse erhöht und es kann bei niedrigeren Temperaturen gearbeitet werden.

Auch ist es vorteilhaft, wenn eine Wandheizung in der Prozesskammer vorgesehen ist, wobei die mittlere Wandtemperatur auf mindestens 50°C einstellbar ist, um eine konstante Prozessumgebung zu definieren und damit die Reproduzierbarkeit der Ergebnisse zu gewährleisten. Für Wandtemperaturen oberhalb von 50°C ist der Einsatz einer zweiten inneren Kammerwand vorteilhaft, die innerhalb der Prozesskammer angeordnet wird und separat geheizt werden kann (Liner). Die Linertemperaturen können dann in Abhängigkeit vom aktuellen Verfahren bis zu einigen 100°C betragen.

Eine weitere vorteilhafte Ausführungsform weist eine Heizung für die Substratauflage auf, wobei die mittlere Temperatur der Substratauflage zwischen 10 und 650°C einstellbar ist Diese dienst der Prozessoptimierung und der Realisierung verschiedener Prozesse.

Mit Vorteil ist mindestens ein Einlass für Precursor direkt in die Reaktionskammer vorgesehen, insbesondere in Kopplung mit einer beheizbaren Precursor-Leitung von der Precursorquelle.

Mit Vorteil ist eine Plasmaquelle für die Durchführung eines ICPECVD-Verfahrens und eines PALD Verfahren mit der Prozesskammer gekoppelt.

Auch ist es möglich, eine Zusatzplasmaquelle z.B. zur Generierung eines Remote-Plasmas für die Durchführung eines PALD-Verfahrens in der vorliegenden Vorrichtung einzusetzen.

Die Aufgabe wird auch durch ein Verfahren zur Beschichtung eines Substrates mit den Merkmalen des Anspruchs 12 gelöst.

Dabei wird in einer gemeinsamen Prozesskammer eine erste Schicht mit einem gepulsten Beschichtungsverfahren, insbesondere einem ALD-Verfahren und eine zweite Schicht mit einem zweiten Plasmabeschichtungsverfahren oder eine erste Schicht mit einem Plasmabeschichtungsverfahren und eine zweite Schicht mit einem gepulsten Beschichtungsverfahren, insbesondere einem ALD-Verfahren auf das Substrat aufgebracht.

In einer vorteilhaften Ausführungsform des Verfahrens wird nach dem Aufbringen der ersten und zweiten Schicht, mindestens eine weitere Schicht mit einem kontinuierlichen oder mit einem nicht-kontinuierlichen Beschichtungsverfahren aufgebracht. Damit lassen sich alternierende Schichten herstellen.

Dabei ist es vorteilhaft, wenn bei der Durchführung des ALD-Verfahrens das Prozessvolumen um das Substrat in der Prozesskammer gegenüber dem Plasmabeschichtungsverfahren verkleinert wird.

Auch können vorteilhafterweise das gepulste Verfahren und das kontinuierliche Verfahren zumindest zeitweise parallel in der gemeinsamen Prozesskammer durchgeführt werden. Mit einem gepulsten Verfahren, insbesondere mit einem ALD-Verfahren werden in der gleichen Prozesskammer, wie für die mit einem nicht-gepulsten Verfahren hergestellten Schichten, Metall-, Metalloxid, -Metallnitrid- und Metalloxinitridschichten sowie, Halbleiteroxid-, Halbleiternitrid- und / oder Halbleiteroxinitridschichten hergestellt.

Mit einem Plasmabeschichtungsverfahren werden Siliziumoxid- , Siliziumnitrid-, Siliziumoxynitridschichten, amorphe Si-Schichten, mikrokristalline Siliziumschichten und /oder diamantähnliche CH-Schichten hergestellt, ebenfalls in der gleichen Prozesskammer, in der ein gepulstes Verfahren durchgeführt wird.

Im Folgenden werden anhand von Zeichnungen einige Ausführungsformen der Erfindung dargestellt. Dabei zeigt
- Fig. 1: eine Vorrichtung zur Beschichtung mit einem Plasma gemäß dem Stand der Technik;
- Fig. 2: eine Vorrichtung zur ALD-Beschichtung gemäß dem Stand der Technik;
- Fig. 3: eine erste Ausführungsform einer Vorrichtung zur Beschichtung mit einem Plasma- und ALD Verfahren in einer gemeinsamen Prozesskammer;
- Fig. 4: eine perspektivische Darstellung der ersten Ausführungsform;
- Fig. 5: eine Detailansicht der Ausführungsform gemäß Fig. 4;
- Fig. 6a: eine zweite Ausführungsform einer Vorrichtung zur in-situ Beschichtung mit einem Plasma- und ALD Verfahren in einer gemeinsamen Prozesskammer;
- Fig. 6b: eine dritte Ausführungsform einer Vorrichtung zur in-situ Beschichtung mit einem Plasma- und ALD Verfahren in einer gemeinsamen Kammer; und
- Fig. 7A-Cdrei: Ausführungsformen für die Fahrweisen der Verfahren.

Bevor eine Ausführungsform für eine nicht-gepulste Plasmabeschichtung und eine gepulste ALD-Beschichtung in einer gemeinsamen Prozesskammer beschrieben wird, werden im Folgenden zunächst typische Betriebsparameter der unterschiedlichen Verfahren beschrieben.

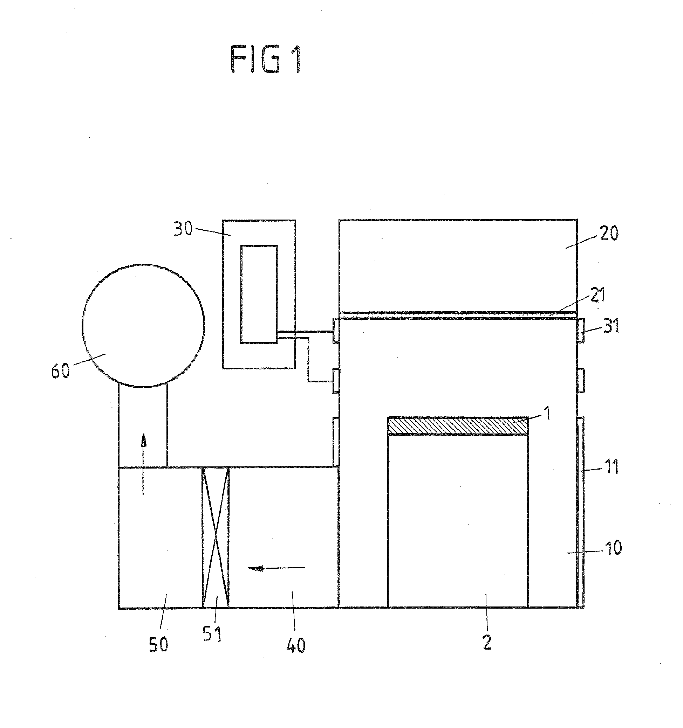

In Fig. 1 ist beispielhaft eine aus dem Stand der Technik bekannte Vorrichtung zur plasmagestützten chemischen Abscheidung (PECVD) - hier eine ICP (inductively coupled plasma)-ECVD - dargestellt.

Das Substrat 1 liegt dabei auf einem geheizten Wafertisch 2 (Substrathalterung) in einer Prozesskammer 10, auch Reaktor genannt. Die Reaktorwände können über eine Wandheizung 11 temperiert werden. Oberhalb der Prozesskammer 10 ist eine Plasmaquelle 20 angeordnet.

Bei einer ICP-Plasmabeschichtung werden z.B. qualitativ hochwertige SiO₂ oder Si₃N₄-Schichten auf dem Substrat 1 abgeschieden. Die typischen Abscheidetemperaturen liegen nicht über 130°C.

Bei einem plasmaunterstützten chemischen Abscheideverfahren (PECVD) erfolgt eine kontinuierliche Abscheidung relativ dicker Schichten auf dem Substrat 1 mit Dicken zwischen 0,1 bis 2 µm und Beschichtungsraten zwischen 20 bis 50 nm/min.

Üblicherweise erfolgt die Plasmabeschichtung in einer zylinderförmigen Prozesskammer 10 mit einem vergleichsweise großen Durchmesser von z.B. 350 mm.

Die Reaktorwand ist mit der Wandheizung 11 auf eine moderate Temperatur einstellbar, z.B. mindestens auf 50°C.

Als Plasmaquelle 20 ist in Fig. 1 eine ICP-Plasmaquelle direkt oberhalb der Prozesskammer 10 angeordnet, wobei das erzeugte Plasma Radikale, Ionen und Photonen aufweist. Die Plasmaquelle 20 ist mit einer dielektrischen Koppelplatte 21 abgeschlossen, die die HF-Anregungsstruktur bei Atmosphärendruck vom eigentlichen Vakuum-Prozessvolumen trennt.

Der Einlass der Prozessgase aus einem Gasquellensystem 30 in die Prozesskammer erfolgt in der dargestellten Ausführungsform ungeheizt und in rotationssymmetrischer Anordnung, wobei die Gaseinlässe 31 z.B. radial an der Wand der Prozesskammer 10 angeordnet sind. In anderen Fällen kann das Gas auch geheizt zugeführt werden. Die Prozessgase für die Plasmabeschichtung werden häufig in Gasflaschen gelagert, die sich in einiger Entfernung von der Prozesskammer befinden. Die Zufuhr der Prozessgase erfolgt dann über Leitungen und Ventilsysteme.

Die Substratauflage, z.B. der Wafertisch 2 ist auf relativ moderate Temperaturen zwischen 10 und 400°C einstellbar.

Das Plasmavolumen zwischen der Substratauflage 2 und der dielektrischen Koppelplatte 21 ist relativ groß, es kann je nach Substratgröße zwischen 10 und 20 l betragen. Zur Vakuumerzeugung wird die Prozesskammer 10 über eine Vakuumleitung 40 mit der Prozesspumpe 50 verbunden; zur Einstellung des Gasdrucks in der Prozesskammer 10 wird ein Druckregler verwendet. Dabei wird der Druck mittels einer Ventilvorrichtung 41, insbesondere mittels eines Drosselventils eingestellt, wie dies in Fig. 1 dargestellt ist.

Als Prozesspumpe 50 dient in dieser Ausführungsform eine Turbomolekularpumpe (TMP) in Kombination mit einer Vorpumpe 60. Grundsätzlich sind aber - je nach Plasmabeschichtungsverfahren - auch andere Typen von Vakuumpumpen als Prozesspumpe 50 einsetzbar.

In diesem Ausführungsbeispiel liegt ein zweistufiges Pumpsystem vor: Eine Vorpumpe 60 erzeugt einen hinreichenden Vordruck für die Turbomolekularpumpe 50 (z.B. eine Drehschieber- oder Trockenpumpe mit einer Förderleistung von 40 bis 500 m³/h).

ALD-Verfahren (thermische ALD-Verfahren (TALD), Plasma ALD-Verfahren (PALD)) dienen zur Herstellung dünner Metall- und Halbleiter-Oxid- bzw. -Nitrid-Schichten oder von Metallfilmen u.a. als Funktionsschichten für Transistoren, Kondensatoren, LEDs, OLEDs, Solarzellen oder Architekturglas.

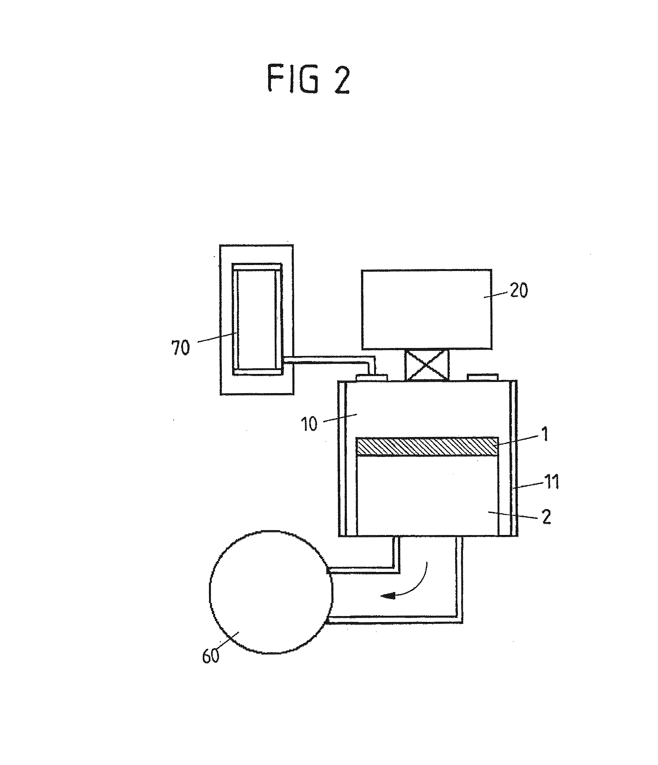

In Fig. 2 ist eine aus dem Stand der Technik grundsätzlich bekannte Vorrichtung dargestellt.

Auch hier wird eine Prozesskammer 10 mit einer darin befindlichen heizbaren Substratauflage, z.B. einem Wafertisch 2 verwendet. Wie bei der in Fig. 1 dargestellten Plasmabeschichtungsvorrichtung, sind die Prozesswände durch eine Wandheizung 11 beheizbar ausgebildet.

Mit ALD-Verfahren werden qualitativ hochwertige Schichten erzeugt, die bei sehr unterschiedlichen Temperaturen abgeschieden werden (oft z.B. von 200 bis 500°C). Bei PALD-Verfahren liegt die Prozesstemperatur in der Regel bei tieferen Temperaturen (z.B. im Bereich von 80 bis 150°C).

Dabei erfolgt eine zyklische Abscheidung von Atomlagenschichten im Schichtdickenbereich von 10 bis 50 nm. Die Beschichtungsraten betragen bei 0,1 nm/Zyklus 0,2 bis 1 nm/min.

Üblicherweise erfolgt die Beschichtung in einer zylinderförmigen Prozesskammer 10 mit einem - verglichen mit einer Plasmabeschichtungsvorrichtung - geringeren Volumen im Bereich von ca. 0,3 bis zu einigen Litern. Die Reaktorwand ist meist höher temperiert als bei Plasmabeschichtungsverfahren, z.B. auf 80 bis 150°C. Die Temperatur der Reaktorwand kann in Abhängigkeit vom Material und den verwendeten Vakuumdichtungen auch höher liegen.

Der Wafertisch 2 als Substratauflage wird im Vergleich zu dem Plasmabeschichtungsverfahren auf höhere Temperaturen geheizt, in der Regel auf 50°C bis 500°C.

Die PALD-Plasmaquelle 20 wird üblicherweise als Remote-Plasma betrieben. Das aktivierte Prozessgas in der Nähe des Substrates 1 enthält dann nur Radikale. Je nach Ausführungsform ist die Plasmaquelle durch einen Vakuumschieber von der Prozesskammer abtrennbar. Auch wird das Prozessvolumen oberhalb des Substrates 1 möglichst klein ausgeführt.

Zur Einleitung der Precursoren in die Prozesskammer werden geheizte, symmetrische Gasverteiler (Showerheads) eingesetzt. Ein Precursorquellensystem 70 selbst ist mit geheizten Prozessgaslinien (z.B. bis 200°C) und geheizten/gekühlten Precursor-Behältern ausgestattet. Im Unterschied zu den Plasmabeschichtungsverfahren werden die Precursor aus Flüssigkeiten oder Feststoffen gewonnen; die Behälter der Precursor sind daher in der Regel relativ nahe zur Prozesskammer 10 angeordnet.

Als Prozesspumpen 60 werden Trocken- oder Drehschieberpumpen mit Förderleistungen von 10 bis 500 m³/h (je nach Größe der Prozesskammer 10) verwendet. Systeme mit Ölpumpen sind mit einem Filter ausgerüstet.

Turbomolekularpumpen werden in der Regel nicht als Prozesspumpen eingesetzt, da die Gefahr der Beschädigung durch Ablagerungen besteht. Eine Turbomolekularpumpe (in Fig. 2 nicht dargestellt) kann aber als Option für ein besseres Basisvakuum dienen.

Ferner wird je nach Anlagenausführung die Vakuumleitung von der Prozesskammer 10 zur Vorpumpe geheizt und das System ohne Druckregler betrieben. In manche Ausführungsformen ist stattdessen ein Absperrventil zum Absperren der Prozesspumpe gegenüber der Prozesskammer integriert

Aus dieser Gegenüberstellung wird deutlich, dass Plasmabeschichtungsverfahren und ALD-Verfahren für unterschiedliche Beschichtungsaufgaben, bei unterschiedlichen Bedingungen und mit unterschiedlichen Apparaturen durchgeführt werden. Die beiden Prozesse sind Beispiele für jeweils ein ungepulstes und ein gepulstes Beschichtungsverfahren.

Aus diesen Gründen werden die beiden Verfahren bei bekannten Lösungen auch in getrennten, unterschiedlichen Prozesskammern durchgeführt, da sich die Prozesse ansonsten gegenseitig beeinflussen würden. Der Transport der Substrate zwischen den Prozesskammern erfolgt dabei häufig über eine mit einem Vakuumroboter ausgerüstete Transferkammer, um die aufgebrachten funktionalen Schichten nicht zu schädigen.

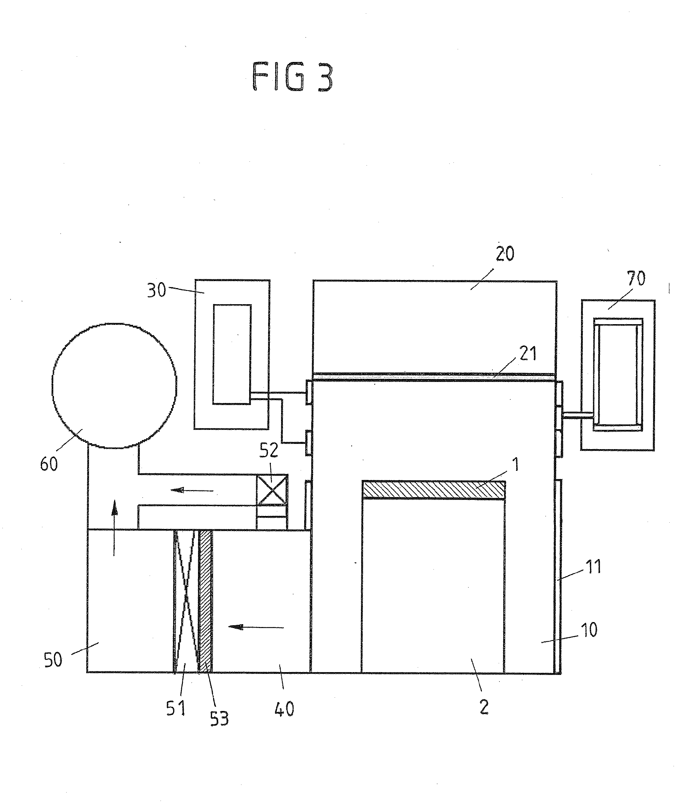

Die erste Ausführungsform, die in Fig. 3 dargestellt ist, geht von einer ICP-Plasmabeschichtungsvorrichtung für ein erstes Plasmabeschichtungsverfahren aus, wie sie z.B. in Fig. 1 dargestellt ist.

Damit auch eine ALD-Beschichtung möglich ist, weist die Ausführungsform gemäß Fig. 3 zwei Quellensysteme 30, 70 für reaktive Substanzen auf, nämlich ein Mittel zur Plasmabeschichtung und ein Mittel zur ALD-Beschichtung.

Es wird für beide Prozesse eine gemeinsame Prozesskammer 10 verwendet, in der eine beheizbare Substratauflage 2 für das Substrat 1 angeordnet ist. Die Wandungen der Prozesskammer 10 weisen eine Heizvorrichtung 11 auf. Oberhalb der Prozesskammer 10 ist eine Plasmaquelle 20 angeordnet, die über eine Koppelplatte 21 mit der Prozesskammer 10 verbunden ist.

Die Prozesskammer 10 ist dabei mit einem kontinuierlich betreibbaren erstem Quellensystem als einem Gasquellensystem 30 für Reaktanden und Trägergase und mit einem gepulst betreibbaren zweitem Quellensystem für Reaktanden und Trägergase als einem Precursorquellensystem 70 gekoppelt. Das erste Quellensystem 30 ist in diesem Fall für eine kontinuierliche Plasmabeschichtung ausgebildet, das zweite Quellensystem 70 für eine gepulste ALD-Beschichtung.

Damit sind die Voraussetzungen für eine Beschichtung eines Substrates mit einem Plasmabeschichtungsverfahren und einem ALD-Verfahren in einer gemeinsamen Prozesskammer 10 geschaffen.

Grundsätzlich kann das zweite Quellensystem 70 auch für andere gepulste Verfahren verwendet werden, wie z.B. Molecular-Layer-Deposition (MLD) oder Chemical-Vapor-Deposition (CVD). Somit sind auch zwei unterschiedliche Plasmabeschichtungsverfahren, von denen eins kontinuierlich, das andere gepulst durchgeführt wird, in einer gemeinsamen Prozesskammer 10 ausführbar.

Das Precursorquellensystem 70 ist dabei seitlich neben der Prozesskammer 10 angeordnet, wobei die Leitungen von dem Precursorquellensystem 70 zur Prozesskammer 10 beheizbar ausgebildet sind. Der Einlass der Precursoren erfolgt direkt durch die Reaktorwand. Dieser Gaseinlass kann durch eine lokale Heizung auf eine höhere Temperatur gebracht werden, als die Wandung der Prozesskammer 10.

Wenn ein PALD-Prozess realisiert werden soll, kann die ICP-Plasmaquelle 20 auch als Plasmaquelle für die Erzeugung des Plasmas für das PALD-Verfahren verwendet werden. Allerdings kann die dielektrische Koppelplatte 21 keine leitenden Schichten vertragen, so dass das PALD-Verfahren ohne weitere Zusatzmaßnahmen auf das Beschichten mit nicht-leitenden Schichten, wie z.B. Oxide oder Nitride beschränkt ist.

Die Wandung der Prozesskammer 10 wird auf mindestens 50°C temperiert. Die Temperatur der Substratauflage 2 wird auf eine Temperatur zwischen 10 und 400 °C eingestellt. Bei diesen Temperaturen sind das Plasmabeschichtungs- und das ALD-Verfahren in derselben Prozesskammer 10 durchführbar.

Um unerwünschte Wechselbeziehungen zwischen Reaktanden des Plasmabeschichtungsverfahrens und des ALD-Verfahrens zu minimieren oder zu vermeiden, kann die Pumpenausstattung modifiziert werden.

Während des kontinuierlichen Plasmabeschichtungsverfahrens kann eine Turbomolekularpumpe 50 als Prozesspumpe verwendet werden, die über die Vakuumleitung 40 mit der Prozesskammer 10 verbunden ist.

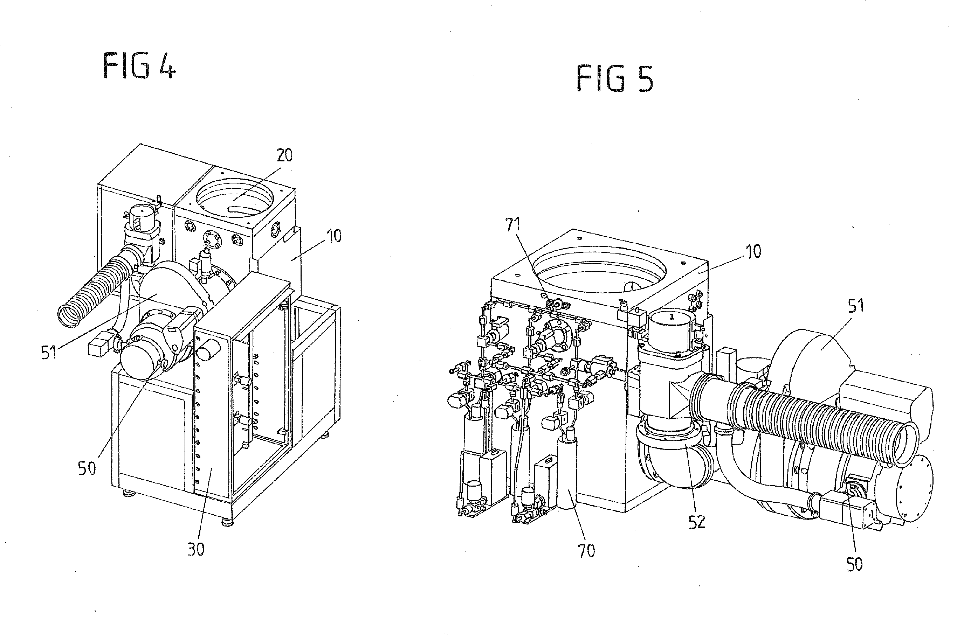

Während das ALD-Verfahren in der Prozesskammer 10 durchgeführt wird, kann die Turbomolekularpumpe 50 durch einen Vakuumsperrschieber 41 (siehe auch Fig. 4 und 5) von der Reaktionskammer 10 getrennt werden. Somit kann die Pumpe 60, die eigentlich als Vorpumpe für die Turbomolekularpumpe 50 arbeitet, über die Vorrichtung 52 an der Vakuumleitung 40 unter Umgehung der Turbomolekularpumpe betrieben werden (siehe Fig. 3). Die Vorrichtung 52 kann dabei als Drossel- oder/und Ventilvorrichtung ausgebildet werden. Vorteilhafterweise kann hier schnell von einer Prozessbedingung zur anderen umgeschaltet werden. Durch diese zeitweise Trennung können keine Ablagerungen vom ALD-Verfahren in die Turbomolekularpumpe 50 gelangen. Eine Beschädigung des Rotors in der Turbomolekularpumpe 50 wird damit vermieden.

Ferner ist es in der dargestellten Ausführungsform möglich, kontinuierlich mit der Vorpumpe 60 und der Turbomolekularpumpe 50 abzupumpen. Um mögliche Ablagerungen von Reaktanden in der Turbomolekularpumpe zu vermeiden, wird hier eine Vorrichtung 53 eingebaut, die die Filterfunktion übernimmt. Die Filterfunktion kann z.B. durch eine gezielt einbaute Kältefalle übernommen werden.

Die Turbomolekularpumpe 50 wird über die Vorrichtung 41 betrieben. Die Vorrichtung 41 kann dabei als Drossel-, Ventil- oder Blendevorrichtung ausgebildet sein. Vorteilhafterweise kann hier der Prozessdruckbereich durch den Einsatz der Turbomolekularpumpe vergrößert werden.

Die Ausführungsform der Fig. 3 wird in den Fig. 4 und 5 in Form von perspektivischen Ansichten dargestellt. In Fig. 4 ist der Prozessraum 10 (Reaktor) ohne Plasmaquelle 20 zu sehen. Hinter dem Reaktor (in der Fig. zum Betrachter hin) ist die Gasquelle 30 angeordnet. Ebenfalls hinter dem Reaktor ist die Turbomolekularpumpe 50mit dem Vakuumschieber 51 angeordnet. Der Aufbau der Beschichtungsvorrichtung ist kompakt ausführbar.

Das Precursorquellensystem 70 ist in Fig. 4 ein Kabinett rechts (im Bild links) neben der Prozesskammer 10 .

In Fig. 5 ist diese Seite genauer darstellt. An der rechten Seite der Prozesskammer 10 sind mehrere Behälter des Precursorquellensystem 70 angeordnet, wobei die Precursoren über beheizbare Leitungen der Prozesskammer 10 zugeführt werden. In Fig. 5 ist auch erkennbar, dass der Sperrschieber 51 zwischen der Prozesskammer 10 und der Turbomolekularpumpe 50 angeordnet ist.

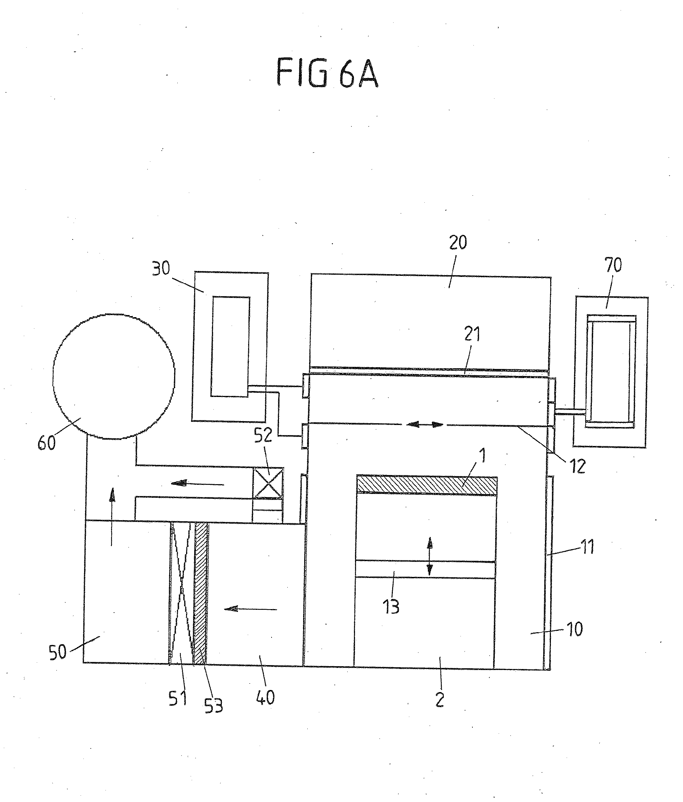

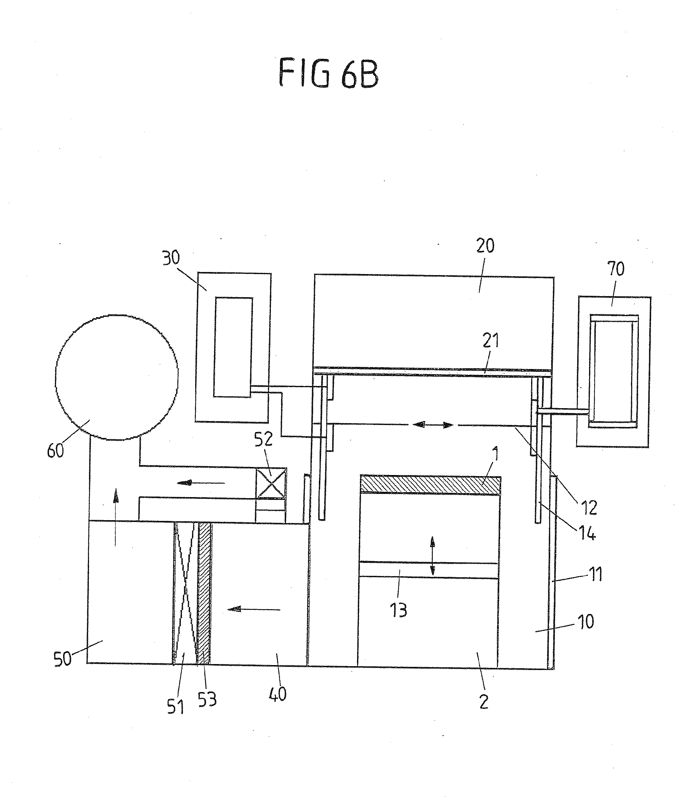

Die in Fig. 3 dargestellte Ausführungsform einer Beschichtungsvorrichtung kann nun um eine Reihe von Details erweitert werden, die einzeln oder zusammen verwendet werden können. Diese Ausführungsformen sind in Fig. 6a und Fig. 6b dargestellt.

So ist es gemäß der Ausführungsform der Figur 6a z.B. möglich, in der Saugleitung der Turbomolekularpumpe 50 eine Abscheidevorrichtung und / oder eine Filtervorrichtung 53 anzuordnen, um Ablagerungen in der Turbomolekularpumpe 50 zu verringern bzw. ganz zu verhindern. Dies bietet insbesondere dann Vorteile, wenn die Turbomolekularpumpe 50 auch beim ALD-Prozess als Prozesspumpe eingesetzt wird. Das hohe Saugvermögen bei niedrigen Prozessdrücken erweitert das ALD-Prozessfenster.

Um das vergleichsweise große Prozessvolumen der Prozesskammer 10 während des ALD-Verfahrens zu optimieren, kann ein Mittel zur Veränderung des Prozessvolumens vorgesehen werden. Eine Möglichkeit besteht darin, eine Blendenvorrichtung 12 mit veränderlicher Öffnung zwischen der dielektrischen Koppelplatte 21 der ICP-Plasmaquelle 20 und der Substratauflage 2 anzuordnen. Bei der kontinuierlichen Plasmabeschichtung ist die Blendenvorrichtung 12 vollständig geöffnet.

Grundsätzlich ist es möglich, dass die Blendenvorrichtung 12 mehr als eine Blende aufweist.

Bei der Durchführung des ALD-Verfahrens wird die Blendenvorrichtung 12 ganz oder teilweise geschlossen, um das Prozessvolumen zu verkleinern. Dies erhöht die Gasaustauschrate über der Substratauflage 2 und senkt den Precursorverbrauch. Wenn ein PALD-Verfahren eingesetzt wird, dann kann die ICP-Plasmaquelle 20 als PALD-Quelle dienen, die oberhalb der teilweise geschlossenen Blendenvorrichtung 12 angeordnet ist. Damit wird ein Quasi-Remote-Plasma erzeugt.

Die Blendenvorrichtung 12 kann dabei vollkommen dichtend ausgebildet sein, z.B. als Vakuumschieber, oder kann durchlässig sein, z.B. als Irisblende, Lochblende oder Gitter.

Alternativ oder zusätzlich kann das Prozessvolumen auch durch eine Hebe- und Senkvorrichtung 13 für die Substratauflage 2 verkleinert werden. Die Verkleinerung des Prozessvolumens während der ALD-Verfahrens-Phase kann dann durch ein Anheben der Subtratauflage 2 in Richtung der Plasmaquelle 20 erreicht werden. Durch die Relativbewegung der Subtratauflage 2 zur Plasmaquelle 20 ist eine einfache Einstellung des Prozessvolumens möglich.

Es ist aber auch möglich, die Beschichtungsvorrichtung mit einem Zusatzplasmaquellensystem 31 auszustatten (siehe z.B. Fig. 1), die ein echtes Remote-Plasma erzeugt. Bei geschlossener Blendenvorrichtung (z.B. einem Schieber, einer Irisblende, einer Lochblende), d.h. bei abgedeckter dielektrischer Koppelplatte 21, ist dann auch eine Abscheidung von Metallen bzw. leitfähigen Schichten möglich.

Gemäß der in Figur 6b gezeigten Ausführungsform ist es auch möglich, innerhalb der Prozesskammer eine zweite innere Kammerwand 14 in Form eines sogenannten Liners anzuordnen, die separat beheizbar ist. Der Einsatz eines solchen Liners ermöglicht die Einstellung von Verfahrenstemperaturen innerhalb der Prozesskammer von bis zu einigen 100°C, was insbesondere während eines ALD-Verfahrens vorteilhaft sein kann.

Im Folgenden wird zusammengefasst, welche Arten von Beschichtungen mit den beschriebenen Ausführungsformen herstellbar sind.

Mit dem Plasmabeschichtungsverfahren (ICPECVD) sind z.B. Siliziumoxid-, Siliziumnitrid-, Siliziumoxynitridschichten, amorphe Si-Schichten, mikrokristalline Siliziumschichten und / oder diamantähnliche CH-Schichten mit Schichtdicken von 0,01 bis 20 µm herstellbar. Die Beschichtungsraten betragen 1 bis 500 nm/min.

Mit dem ALD-Verfahren sind in der gleichen Prozesskammer 10 Metall-, Metalloxid-, -Metallnitrid- und Metalloxinitridschichten, Halbleiteroxid-, Halbleiternitrid- und / oder Halbleiteroxinitridschichten in Schichtdicken zwischen wenige Atomlagen und 100 nm herstellbar. Auch die Kombination von mehreren Schichtarten ist hier möglich. Die Beschichtungsraten betragen bis 2 nm/min.

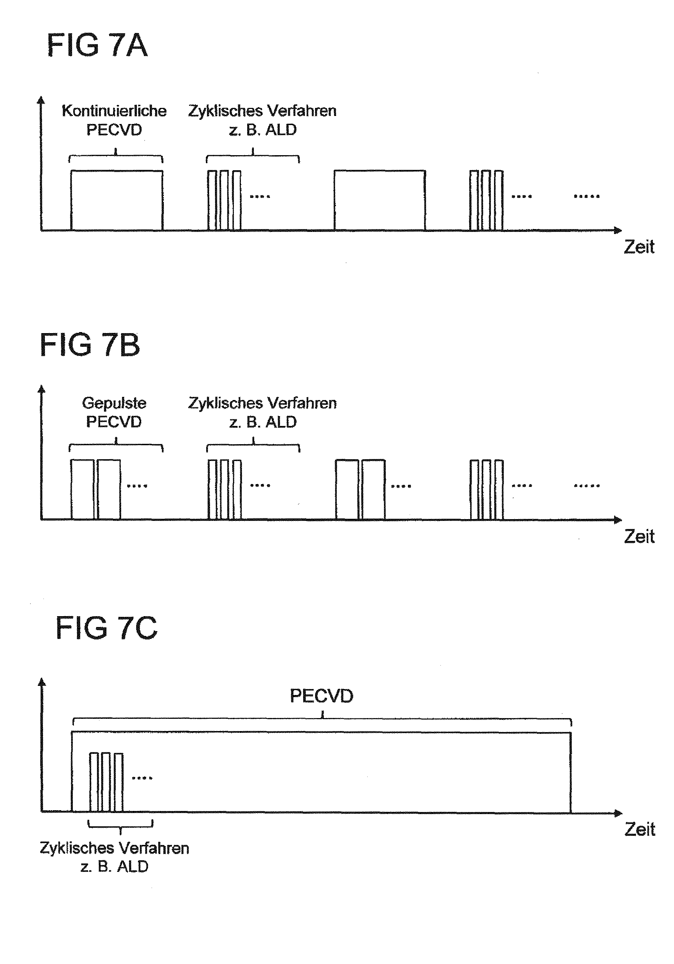

In den Fig. 7A bis C werden unterschiedliche Fahrweisen von Beschichtungsverfahren beschrieben. Die Zeichnungen sind nicht maßstabsgerecht, da sie das Prinzip zeigen sollen.

In Fig. 7A ist eine sequentielle Ausführung eines kontinuierlichen Beschichtungsverfahrens und eines gepulsten Beschichtungsverfahrens dargestellt. Hier wird mit einem kontinuierlichen PECVD Verfahren begonnen, was typischerweise länger als 1 Minute auf das Substrat 1 einwirkt. In der gemeinsamen Prozesskammer 10 wird anschließend als zyklisches Verfahren ein ALD-Verfahren ausgeführt, bei dem jeder Zyklus einige bis einige zehn Sekunden dauert. Die Anzahl der Zyklen hängt von den Materialien, den Prozessbedingungen und den gewünschten Schichteigenschaften ab.

Anschließend folgt wieder ein kontinuierliches PECVD-Verfahren, gefolgt von einem ALD-Verfahren. Diese Abfolge wird so lange fortgeführt, bis das gewünschte Beschichtungsergebnis erreicht ist.

In Fig. 7B ist eine Ausführungsform dargestellt, bei der zwei nicht-kontinuierliche Verfahren sequentiell verwendet werden. Begonnen wird mit einem gepulsten PECVD-Verfahren, bei dem die einzelnen Pulse typischerweise länger als 1 Minute dauern. Nach diesem Verfahren wird in der gemeinsamen Prozesskammer 10 ein gepulstes Verfahren, hier ein ALD-Verfahren durchgeführt, bei dem die einzelnen Zyklen typischerweise einige bis einige zehn Sekunden dauern. Dies wird solange wiederholt, bis das gewünschte Beschichtungsergebnis erreicht ist.

In Fig. 7C ist eine parallele Durchführung von Beschichtungsverfahren in einer gemeinsamen Prozesskammer 10 dargestellt. Während einer vorbestimmbaren Prozesszeit wird ein kontinuierliches PECVD-Verfahren durchgeführt, während gleichzeitig in der gleichen Prozesskammer 10 ein zyklisches Verfahren, z.B. ein ALD-Verfahren durchgeführt wird.

In allen drei Ausführungsbeispielen der Fig. 7A-7C wird ein gepulstes (Plasma-)Beschichtungsverfahren mit einem weiteren Plasmabeschichtungsverfahren in einer gemeinsamen Prozesskammer 10 durchgeführt.

### Bezugszeichenliste

- 1: Substrat
- 2: Substratauflage, Wafertisch (heizbar)

- 10: Prozesskammer
- 11: Wandheizung
- 12: Blendenvorrichtung
- 13: Hebe- und Senkvorrichtung für Substratauflage
- 14: zweite beheizbare innere Kammerwand (Liner)

- 20: Plasmaquelle
- 21: Koppelplatte

- 30: erstes Quellensystem (Gasquellensystem)
- 31: Zusatzplasmaquellensystem

- 40: Vakuumleitung
- 41: Ventilvorrichtung/Vakuumsperrschieber/Drosselvorrichtung
- 50: Turbomolekularpumpe
- 52: Drosselvorrichtung
- 53: Filtervorrichtung / Abscheidevorrichtung
- 60: Vorpumpe
- 70: zweites Quellensystem (Precursorquellensystem)
- 71: Precursoreinlass

## Patentansprüche

1. Beschichtungsvorrichtung für Substrate,
**gekennzeichnet durch**
eine Prozesskammer (10), die mit mindestens einem ersten Quellensystem (30) für Reaktanden und gegebenenfalls Trägergase und mindestens einem gepulst betreibbaren zweiten Quellensystem (70) für Reaktanden und gegebenenfalls Trägergase gekoppelt ist, so dass mindestens zwei Plasmabeschichtungsverfahren in der gemeinsamen Prozesskammer (10) durchführbar sind.

2. Beschichtungsvorrichtung nach Anspruch 1, **dadurch gekennzeichnet, dass** das zweite Quellensystem (70) ein gepulstes Quellensystem (70) für ein ALD-Verfahren, ein MLD-Verfahren oder ein CVD-Verfahren aufweist.

3. Beschichtungsvorrichtung nach Anspruch 1 oder 2, **dadurch gekennzeichnet, dass** eine gepulste ALD-Beschichtung und eine kontinuierliche Plasmabeschichtung in der gemeinsamen Prozesskammer (10) durchführbar sind.

4. Beschichtungsvorrichtung nach mindestens einem der vorhergehenden Ansprüche, **dadurch gekennzeichnet, dass** das erste Quellensystem (30) kontinuierlich betreibbar ist.

5. Beschichtungsvorrichtung nach mindestens einem der vorhergehenden Ansprüche, **gekennzeichnet durch** ein Mittel, insbesondere einen Sperrschieber, zur zeitweisen Abkopplung einer Prozesspumpe (50) von der Prozesskammer (1) .

6. Beschichtungsvorrichtung nach mindestens einem der vorhergehenden Ansprüche, **gekennzeichnet durch** eine Filtervorrichtung und / oder Abscheidevorrichtung (53) in der Saugleitung einer Prozesspumpe (50), insbesondere für eine Prozesspumpe, die als Turbomolekularpumpe ausgebildet ist.

7. Beschichtungsvorrichtung nach mindestens einem der vorhergehenden Ansprüche, **gekennzeichnet durch** ein Mittel zur Anpassung des Prozessvolumens in der Prozesskammer (10) in Abhängigkeit vom Beschichtungsverfahren, bevorzugt in Form einer Blendenvorrichtung (12) und / oder eines Mittels (13) zur Bewegung der Substratauflage (2) relativ zur Plasmaquelle (20) .

8. Beschichtungsvorrichtung nach mindestens einem der vorhergehenden Ansprüche, **gekennzeichnet durch** eine Wandheizung (11) der Prozesskammer (10), wobei die mittlere Wandtemperatur auf mindestens 50°C einstellbar ist.

9. Beschichtungsvorrichtung nach mindestens einem der vorhergehenden Ansprüche, **gekennzeichnet durch** eine in der Prozesskammer (10) angeordnete zweite beheizbare innere Kammerwand (14).

10. Beschichtungsvorrichtung nach mindestens einem der vorhergehenden Ansprüche, **gekennzeichnet durch** mindestens einen Einlass für Precursor direkt in die Reaktionskammer (10), insbesondere in Kopplung mit einer beheizbaren Precursor-Leitung von der Precursorquelle (70).

11. Beschichtungsvorrichtung nach mindestens einem der vorhergehenden Ansprüche, **gekennzeichnet durch** eine Plasmaquelle (20) für die Durchführung eines ICPECVD-Verfahrens und eines PALD Verfahrens und ggf. einer Zusatzplasmaquelle (31) zur Generierung eines Remote-Plasmas für die Durchführung eines PALD Verfahrens.

12. Verfahren zur Beschichtung eines Substrates,
**dadurch gekennzeichnet, dass** in einer gemeinsamen Prozesskammer (10) eine erste Schicht mit einem gepulsten Beschichtungsverfahren, insbesondere einem ALD-Verfahren und eine zweite Schicht mit einem zweiten Plasmabeschichtungsverfahren oder eine erste Schicht mit einem Plasmabeschichtungsverfahren und eine zweite Schicht mit einem gepulsten Beschichtungsverfahren, insbesondere einem ALD-Verfahren auf das Substrat (1) aufgebracht wird.

13. Verfahren nach Anspruch 12, **dadurch gekennzeichnet, dass** nach dem Aufbringen der ersten und zweiten Schicht, mindestens eine weitere Schicht mit einem kontinuierlichen oder mit einem nicht-kontinuierlichen Beschichtungsverfahren aufgebracht wird.

14. Verfahren nach Anspruch 12 oder 13, **dadurch gekennzeichnet, dass** bei der Durchführung des ALD-Verfahrens das Prozessvolumen um das Substrat (1) in der Prozesskammer (10) gegenüber dem anderen Plasmabeschichtungsverfahren verkleinert wird.

15. Verfahren nach mindestens einem der Ansprüche 12 bis 14, **dadurch gekennzeichnet, dass** das gepulste Plasmabeschichtungsverfahren und ein kontinuierliches Plasmabeschichtungsverfahren zumindest zeitweise parallel in der gemeinsamen Prozesskammer (10) durchgeführt werden.

16. Verfahren nach mindestens einem der Ansprüche 12 bis 15, **dadurch gekennzeichnet, dass** mit einem gepulsten Verfahren, insbesondere mit einem ALD-Verfahren in der gleichen Prozesskammer (10) Metall-, Metalloxid, - Metallnitrid- und Metalloxinitridschichten sowie, Halbleiteroxid-, Halbleiternitrid- und / oder Halbleiteroxinitridschichten hergestellt werden.
